Europäisches Patentamt

European Patent Office

Office européen des brevets

(11) Publication number: **0 501 243 A1**

## EUROPEAN PATENT APPLICATION

(21) Application number: **92102425.3**

(22) Date of filing: **13.02.92**

(51) Int. Cl.5: **G03F 7/16**, G03F 7/039

(30) Priority: **14.02.91 JP 20922/91**

(43) Date of publication of application:
**02.09.92 Bulletin 92/36**

(84) Designated Contracting States:
**DE GB NL**

(71) Applicant: **Nippon Paint Co., Ltd.**
**2-1-2, Oyodokita, Kita-ku**
**Osaka-shi Osaka-fu(JP)**

(72) Inventor: **Matsumura, Akira**
**1-72-15, Kuzuhaoka**
**Hirakata-shi, Osaka-fu(JP)**

(74) Representative: **Hansen, Bernd, Dr.**
**Dipl.-Chem. et al**
**Hoffmann, Eitle & Partner Patent- und**
**Rechtsanwälte Arabellastrasse 4 Postfach**
**81 04 20**
**W-8000 München 81(DE)**

(54) Positive type photosensitive electrocoating resin composition.

(57) Disclosed is an improved photosensitive electrocoating resin composition in which chemically stable groups are introduced instead of naphthoquinone diazide groups, so that photosensitivity and developability are significantly enhanced by reducing side reactions. The present invention provides a positive type photosensitive electrocoating resin composition comprising;

(A) a polymer having an ionic hydrophilic group and a branched group which is unstable against acid, or a polymer mixture of a polymer having an ionic hydrophilic group and a polymer having a branched group which is unstable against acid,

(B) a neutralizing agent capable of neutralizing said ionic hydrophilic group,

(C) an acid generating agent which generates an acid in response to a light irradiation, and

(D) an aqueous medium.

EP 0 501 243 A1

## FIELD OF THE INVENTION

The present invention relates to a positive type photosensitive electrocoating resin composition. More particularly, it relates to a positive type photosensitive electrocoating resin composition capable of forming a thin and uniform photoresist layer on a substrate, such as a printed circuit board, a color filter or an article having wide area and complicated shape.

## BACKGROUND OF THE INVENTION

A positive type resist composition is disclosed in Japanese Kokoku Publication 2-27660 corresponding to USP 4,491,628. The resin composition comprises a polymer (e.g. polystyrene) repeatedly having groups, such as t-butyl esters or t-butyl carbonates, and a photopolymerization initiator. Upon irradiating ultraviolet onto the resin composition, the photopolymerization initiator generates acids which change the t-butyl esters or t-butyl carbonates to corresponding base-soluble phenols or base-soluble carboxylic acids, which are developable with a basic solution.

Since the resist composition inherently has no polar therein, it should be employed in the form of an organic solvent solution. The organic solvent, however, is not preferred in view of environmental pollution. Coating of this resist composition is generally conducted by a roll coater, a curtain coater, a spin coater and a similar method, but it shows poor coating efficiency onto the substrate even if a large amount of the resist composition is used, thus a remaining amount of the resist composition on the substrate being insufficient. It is also difficult to form a resist layer with thin and uniform thickness on a large area substrate having more than square of 300 mm. Especially, in case where the substrate has a complicated shape with rough surface or is a circuit board with through holes, it is more difficult to uniformly coat the resist composition on such substrates or inside the through holes.

## SUMMARY OF THE INVENTION

In order to overcome the mentioned problems, the present inventors proposed a photosensitive resin composition which can be coated by electrocoating (see Japanese Kokai Publication 63-281154). The inventors further provide an improved photosensitive electrocoating resin composition in which chemically stable groups are introduced instead of naphthoquinone diazide groups, so that photosensitivity and developability are significantly enhanced by reducing side reactions. The improved resin composition also keeps the advantages of the Kokai publication, i.e. high coating efficiency, thin and uniform coating onto a substrate with complicated shape or large area and no environmental pollution. Accordingly, the present invention provides a positive type photosensitive electrocoating resin composition comprising;

(A) a polymer having an ionic hydrophilic group and a branched group which is unstable against acid, or a polymer mixture of a polymer having an ionic hydrophilic group and a polymer having a branched group which is unstable against acid,

(B) a neutralizing agent capable of neutralizing said ionic hydrophilic group,

(C) an acid generating agent which generates an acid in response to a light irradiation, and

(D) an aqueous medium.

## DETAILED DESCRIPTION OF THE INVENTION

In the polymer (A), the ionic hydrophilic group is neutralized with the neutralizing agent (B) to form a neutralized salt ion group and therefore the polymer (A) is electrodeposited onto a substrate to be coated. The ionic hydrophilic group is preferably an acid group, such as a carboxylic group, a sulfonic group, a phosphonic group, a mixture thereof and the like.

The branched group which is unstable against acid is preferably a t-butyl ester of a carboxylic acid or a t-butyl carbonate of a phenol, but including a trityl, benzhydryl or benzyl ester of a carboxylic acid or a trityl, benzhydryl or benzyl carbonate of a phenol. The group is decomposed with acid to generate an alkali-soluble group, thus developing with an alkali developer.

The polymer (A) can be either a polymer (i) having an ionic hydrophilic group and a branched group which is unstable against acid, or a polymer mixture (ii) of a polymer having an ionic hydrophilic group and a polymer having a branched group which is unstable against acid. It can be a mixture of the polymer (i) and a polymer mixture (ii).

The polymer (i) may be prepared by copolymerizing a monomer having the ionic hydrophilic group, a monomer having the branched group which is unstable against acid and optionally a copolymerizable monomer therewith.

Examples of the monomers having the ionic hydrophilic are (meth)acrylic acid, (meth)-acrylamide sulfonic acid, a mixture thereof and the like.

Examples of the monomers having the branched group which is unstable against acid are p-t-butoxycarbonyloxy-alpha-methylstyrene,p-t-butoxycarbonyloxystyrene, t-butyl-p-vinyl benzoate, t-butyl-p-isopropenylphenyloxyl acetate, t-butyl methacrylate, a mixture thereof and the like.

The copolymerizable monomers includes olefins or diolefins, such as styrene, alpha-methylstyrene, alpha-ethylstyrene, ethylene, propylene, butylene, amylene, hexylene, butadiene-1,3, isoprene and the like; halogenized monoolefins or diolefins, such as alpha-chlorostyrene, alpha-bromostyrene, 2,5-dichlorostyrene, 2,5-dibromostyrene, 3,4-dichlorostyrene and the like; unsaturated acid esters, such as vinyl acetate, vinyl propionate, vinyl butylate, vinyl isobutylate, vinyl valerate, vinyl, caproate, vinyl enanthate, vinyl benzoate, vinyl toluate, vinyl-p-chlorobenzoate, methyl (meth)acrylate, ethyl (meth)acrylate, propyl (meth)-acrylate, isopropyl (meth)acrylate, butyl (meth)-acrylate, isobutyl (meth)acrylate, amyl (meth)-acrylate, hexyl (meth)acrylate, 2-ethylhexyl (meth)-acrylate, heptyl (meth)acrylate, octyl (meth)-acrylate, 3,5,5-trimethylhexyl (meth)acrylate, decyl (meth)acrylate, dodecyl (meth)acrylate, dimethyl maleate, diethyl maleate, diallyl maleate, dimethyl fumarate, diethyl fumarate, dimethallyl fumarate and diethyl glutarate; allyl halides or cyanides, such as allyl chloride, allyl cyanide, allyl bromide, allyl fluoride, allyl iodide and allyl chloridecarbonate; unsaturated nitriles, such as acrylonitrile, methacrylonitrile, ethacrylonitrile, 3-octenenitrile, crotonitrile and oleonitrile; a mixture thereof; and the like.

A copolymerizing process of the above polymer is known to art, for example the monomer mixture is copolymerized at a temperature of 50 to 200 °C for 3 to 10 hours in the presence or absence of an organic solvent. The copolymerization is initiated with a polymerization initiator, such as azobis(2,4-dimethylvaleronitrile), t-butylperoxy-2-ethyl hexanoate and the like.

The polymer (i) may also be prepared by copolymerizing a monomer having a reactive group to form a polymer which is then modified to introduce the ionic hydrophilic group or the branched group which is unstable against acid. For example, hydroxylalkyl methacrylate is polymerized to form a homopolymer in which the carboxyl group is reacted with t-butanol to form a t-butyl ester and the hydroxyl group is reacted with an acid anhydride in the presence of salt (e.g. pyridine) to form a carboxylic group.

The polymer (i) preferably has an acid value of 20 to 150, more preferably 50 to 100 and a molecular weight of 5,000 to 100,000, more preferably 7,000 to 50,000. Numbers in one polymer molecule of the branched groups which are unstable against acid are not limited, but preferably 20 to 95, more preferably 50 to 85.

The polymer (A) may also be a polymer mixture (ii) of a polymer having an ionic hydrophilic group and a polymer having a branched group which is unstable against acid.

The polymer having an ionic hydrophilic group may be prepared by polymerizing the monomer having an ionic hydrophilic group and the copolymerizable monomer. The polymer may also be prepared by preparing a polymer having reactive groups which are then changed to ionic hydrophilic groups. The polymer having an ionic hydrophilic group preferably has an acid value of 20 to 95, more preferably 40 to 90, and a number average molecular weight of 5,000 to 100,000, more preferably 7,000 to 80,000, but these are not limited and are varied by for example mixing weight ratio.

The polymer having a branched group which is unstable against acid may be prepared by polymerizing the monomer having a branched group which is unstable against acid and the copolymerizable monomer. The polymer may also be prepared by preparing a polymer having reactive groups which are then changed to the branched groups which are unstable against acid. The polymer having a branched group which is unstable against acid preferably has an acid value of 20 to 95, more preferably 40 to 80, and a number average molecular weight of 5,000 to 100,000, more preferably 7,000 to 80,000, but these are not limited and are varied by for example mixing weight ratio.

In the polymer mixture (ii), the polymer having a branched group which is unstable against acid is present in an amount of 20 to 95 % by weight, preferably 50 to 85 % by weight, based on the weight of the polymer mixture (ii).

The neutralizing agent (B) of the present invention is one which is capable of neutralizing the ionic hydrophilic group to form a neutralized salt ion group. The agent (B) includes an inorganic base and an organic base. Examples of the inorganic bases are potassium hydroxide, sodium hydroxide, potassium carbonate, sodium carbonate and ammonia. Examples of the organic bases are tertiary amines (e.g. trimethylamine) and alkanolamines (e.g. ethanolamine). The bases can be used solely or in combination.

The acid generating agent (C) which generates an acid in response to a light irradiation may be an onium salt which is known to the art. Typical examples of the initiators are diaryliodonium salts, triarylsulfonium salts and triarylselenium salts. Preferred counter anions are metal complex halogenates, such as tetrafluoroborates, trifluoromethanesulfonate, hexafluoroantimonate, hexafluoroarsenate and hexafluorophosphate. These acid generating agent (C) generates strong acids in response to a light irradiation, which attacks the branched groups which are unstable against acid to decompose to release carboxyl groups or phenolic acid groups.

The aqueous medium (D) used in the present invention mainly contains water, i.e. deionized water, but other organic solvent (e.g. alcohols, ketones, hydrocarbones) may contain in a small amount.

The resist composition may contain a photosensitizer in order to be sensitive with a light having wave lengths within ultraviolet to visible light. The photosensitizer includes polycyclic aromatic compounds, such as pyrene and perylene; other dyes, such as acrydine; and the like. The composition may also contain an organic solvent, a dye, a pigment and the like.

The photosensitive electrocoating resin composition of the present invention contains the polymer (A) in an amount of 80 to 99 % by weight, preferably 90 to 98 % by weight, the neutralizing agent (B) in an amount of 1 to 20 % by weight, preferably 2 to 10 % by weight, the acid generating agent (C) in an amount of 0.1 to 50 % by weight, preferably 1 to 30 % by weight and optionally the photosensitizer in an amount of 0 to 10 % by weight, preferably 0.1 to 20 % by weight, % by weight being based on the total solid content of the composition, but these amounts are not limited. The resin composition generally has a solid content of 5 to 20 % by weight.

The resist composition of the present invention may be prepared by mixing the above components. Mixing is conducted in a cool and dark place. The obtained composition is electrocoated on a substrate to form a photoresist layer. For example, the substrate to be coated is dipped in the aqueous solution of the resin composition of the present invention and then applied between the substrate and a counter electrode to form a deposited film on the substrate. The electrocoated substrate is rinsed with water and then dried to form a resin layer. The layer is exposed to light through a positive film, and then developed to form a photoresist. The substrate to be coated includes an electroconductive material, such as a copper surface substrate and a glass plate having a transparent electrode (ITO) thereon. The light source for irradiating light includes a ultrahigh pressure mercury lamp, a high pressure mercury lamp, a metal halide lamp, a xenone lamp, a low pressure mercury lamp and the like. The development can be conducted with an alkaline solution for positive type. Examples of the alkaline compounds for the developers are sodium hydroxide, potassium hydroxide, sodium carbonate, potassium carbonate, sodium metasilicate, potassium metasilicate and the like. The alkaline developer solution may contain the alkaline compound in an amount of 0.1 to 10 % by weight.

EXAMPLES

The present invention is illustrated by the following examples which, however, are not to be construed as limiting the present invention to their details.

Preparation Example 1

(Preparation of a polymer having an ionic hydrophilic group)

A one liter separable flask equipped with a thermometer, a nitrogen introducing tube, a condenser and a mixer was charged with 219.1 g of methyl methacrylate, 140.9 g of lauryl methacrylate, 90 g of hydroxyethyl methacrylate, 150.0 g of methacrylic acid, 12.0 g of azobis(2,4-dimethyl valeronitrile) and 300.0 g of buthyl cellosolve, and mixed at 90 °C for 7 hours in a nitrogen atmosphere. After cooling, the polymer had a glass transition temperature of 50 °C, an acid value of 163 and a number average molecular weight (GPC) of 7,500.

Preparation Example 2

(Preparation of a polymer having a branched group which is unstable against acid)

A one liter separable flask equipped with a thermometer, a nitrogen introducing tube, a condenser and a mixer was charged with 34.7 g of methyl methacrylate, 55.3 g of lauryl methacrylate, 510.0 g of t-butyl methacrylate, 6.0 g of azobis(2,4-dimethyl valeronitrile) and 300.0 g of buthyl cellosolve, and mixed at 90 °C for 6 hours in a nitrogen atmosphere. After cooling, the polymer had a glass transition temperature of 80 °C and a number average molecular weight (GPC) of 25,000.

Preparation Example 3

(Preparation of a polymer having both an ionic hydrophilic group and a branched group which is unstable against acid)

A one liter separable flask equipped with a thermometer, a nitrogen introducing tube, a condenser and a mixer was charged with 36.8 g of methyl methacrylate, 480.0 g of t-butyl methacrylate, 53.2 g of lauryl methacrylate, 30.0 g of acrylic acid, 60.0 g of azobis(2,4-dimethyl valeronitrile) and 300.0 g of buthyl cellosolve, and mixed at 90 °C for 8 hours in a nitrogen atmosphere. After cooling, the polymer had a glass transition temperature of 80 °C, an acid value of 39 and a number average molecular weight (GPC) of 32,000.

Example 1

A mixture was prepared by mixing 45.6 g of the polymer of Preparation Example 1, 152.0 g of the polymer of Preparation Example 2, 4.3 g of triethylamine and 30.0 g of methyl ethyl ketone, to which triphenylsulfonium hexafluoroantimonate was added in an amount of 20 % by weight based on the total weight of the polymers. To the content, 2,050 g of deionized water was added and adjust to a nonvolatile content of 10 % to obtain an electrodepositing solution.

The solution was charged in a metal vessel, in which a metal substrate to be coated was dipped. A positive electrode was connected with the metal substrate and a negative electrode was connected with the metal vessel, and electrocoating was conducted at 2.5 volt for 30 seconds. The coated substrate was then taken out from the vessel and rinsed with water. It was dried at 100 °C for 5 minutes to obtain a resist layer with 1.8 micrometer on the substrate.

The resist layer was exposed to a high pressure mercury lamp at 100 mJ/cm$^2$ through a positive film having a certain patter. Thereafter, it was heated at 125 °C for 3 minutes and developed with a 0.5 % aqueous sodium hydroxide solution at 50 °C for 60 seconds to obtain a positive image having high resolving power.

Example 2

A mixture was prepared by mixing 152 g of the polymer of Preparation Example 3, 5.7 g of triethylamine and 30.0 g of methyl ethyl ketone, to which triphenylsulfonium hexafluoroantimonate was added in an amount of 25 % by weight based on the total weight of the polymers. To the content, 1,120 g of deionized water was added and adjust to a nonvolatile content of 10 % to obtain an electrodepositing solution.

The solution was charged in a metal vessel, in which a metal substrate to be coated was dipped. A positive electrode was connected with the metal substrate and a negative electrode was connected with the metal vessel, and electrocoating was conducted at 3.0 volt for 60 seconds. The coated substrate was then taken out from the vessel and rinsed with water. It was dried at 100 °C for 5 minutes to obtain a resist layer with 1.6 micrometer on the substrate.

The resist layer was exposed to a high pressure mercury lamp at 150 mJ/cm$^2$ through a positive film having a certain patter. Thereafter, it was heated at 125 °C for 5 minutes and developed with a 0.5 % aqueous sodium hydroxide solution at 50 °C for 60 seconds to obtain a positive image having high resolving power.

According to the present invention, the ionic hydrophilic group is introduced into the positive type photosensitive resin to become electrocoatable. The photosensitive resin composition of the present invention can form a thin and uniform resist layer on a rough or large area surface or in through holes of circuit boards. These features are not obtained in the conventional positive type photosensitive resin composition which has to be coated by spin coating or roll coater coating. The branched group which is unstable against acid is chemically stable, thus enhancing photosensitivity and developability. The composition employs water as solvent and therefore environmental pollution problems occur.

**Claims**

1.  A positive type photosensitive electrocoating resin composition comprising;
    (A) a polymer having an ionic hydrophilic group and a branched group which is unstable against acid, or a polymer mixture of a polymer having an ionic hydrophilic group and a polymer having a branched group which is unstable against acid,
    (B) a neutralizing agent capable of neutralizing said ionic hydrophilic group,
    (C) an acid generating agent which generates an acid in response to a light irradiation, and
    (D) an aqueous medium.

2.  The positive type photosensitive electrocoating composition according to Claim 1 wherein said ionic hydrophilic group is selected from the group consisting of an acid group, such as a carboxylic group, a sulfonic group, a phosphonic group and a mixture thereof.

3.  The positive type photosensitive electrocoating composition according to Claim 1 wherein said branched group which is unstable against acid is selected from the group consisting of a t-butyl ester of a carboxylic acid and a t-butyl carbonate of a phenol.

4.  The positive type photosensitive electrocoating composition according to Claim 1 wherein said polymer (i) is a vinyl polymer prepared by copolymerizing a monomer having the ionic hydrophilic group, a monomer having the branched group which is unstable against acid and optionally a copolymerizable monomer therewith.

5.  The positive type photosensitive electrocoating composition according to Claim 1 wherein said polymer having an ionic hydrophilic group in said polymer mixture (ii) is a vinyl polymer prepared by polymerizing a monomer having an ionic hydrophilic group and a copolymerizable monomer.

6. The positive type photosensitive electrocoating composition according to Claim 1 wherein said polymer having a branched group which is unstable against acid in said polymer mixture (ii) is prepared by polymerizing a monomer having a branched group which is unstable against acid and a copolymerizable monomer.

7. The positive type photosensitive electrocoating composition according to Claim 1 wherein said nuetralizing agent (B) is selected from the group consisting of potassium hydroxide, sodium hydroxide, potassium carbonate, sodium carbonate, ammonia, trimethylamine and ethanolamine.

8. The positive type photosensitive electrocoating composition according to Claim 1 wherein said acid generating agent (C) is an onium salt.

9. The positive type photosensitive electrocoating composition according to Claim 1 wherein said acid generating agent is selected from the group consisting of diaryliodonium salts, triarylsulfonium salts and triarylselenium salts.

10. The positive type photosensitive electrocoating composition according to Claim 1 comprising said polymer (A) in an amount of 80 to 99 % by weight, said neutralizing agent (B) in an amount of 1 to 20 % by weight and said acid generating agent (C) in an amount of 0.1 to 50 % by weight, % by weight being based on the total solid content of the composition.

11. The positive type photosensitive electrocoating composition according to Claim 1 wherein said resin composition has a solid content of 5 to 20 % by weight.

European Patent Office

# EUROPEAN SEARCH REPORT

Application Number

EP  92 10 2425

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-0 265 387 (CIBA-GEIGY AG) <br> * column 4, paragraph 2 * <br> --- | 1-7 | G03F7/16 <br> G03F7/039 |
| A | EP-A-0 354 018 (NIPPON PAINT CO LTD) <br> * claims * <br> --- | 1-11 | |
| A | EP-A-0 301 101 (NIPPON PAINT CO LTD) <br> * claims * <br> --- | 1 | |
| P,A | US-A-5 045 431 (ALLEN R.D. ET AL) <br> * claims * <br> --- | 1 | |
| P,A | EP-A-0 469 584 (NIPPON PAINT CO LTD) <br> * claims * <br><br> ----- | 1 | |
| | | | **TECHNICAL FIELDS SEARCHED (Int. Cl.5 )** <br><br> G03F |

| | | |
|---|---|---|
| Place of search <br> THE HAGUE | Date of completion of the search <br> 03 JUNE 1992 | Examiner <br> LUDI M.M.B. |

The present search report has been drawn up for all claims

**CATEGORY OF CITED DOCUMENTS**

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

....................................................................................................

& : member of the same patent family, corresponding document

EPO FORM 1503 03.82 (P0401)